# DEMANDE DE BREVET EUROPEEN

(11) **EP 4 521 134 A1**
(43) Date de publication de la demande: **12.03.2025**
(21) Numéro de dépôt: 24198713.0
(22) Date de dépôt: 05.09.2024
(51) Int. Cl.: G01R 31/69

(54) **DISPOSITIF DE RÉFLECTOMÉTRIE POUR LA DÉTECTION DE DÉFAUTS SUR UN CONNECTEUR D'UN RÉSEAU ÉLECTRIQUE**

(30) Priorité: 08.09.2023 FR 2309469
(71) Demandeur: NAVAL Group, 75015 Paris (FR)
(72) Inventeur: KERAUDREN, Philippe, 50104 CHERBOURG-OCTEVILLE CEDEX (FR); TOQUET, Nicolas, 50104 CHERBOURG-OCTEVILLE CEDEX (FR)
(74) Mandataire: Lavoix

(57) **Abrégé**

L'invention concerne un dispositif (10) de réflectométrie pour la détection de défauts sur un connecteur (100) d'un réseau électrique.

Le dispositif comprend :
- un premier corps (20) ; et des premiers éléments (24) de connexion, solidaires dudit premier corps ; le premier corps (20) et la pluralité de premiers éléments (24) de connexion étant aptes à s'assembler au connecteur (100) dans une configuration d'assemblage.
- un deuxième corps (22) solidaire du premier corps ; des deuxièmes éléments (25) de connexion, solidaires du deuxième corps ; et des organes (26) de liaison électrique, disposés dans le premier corps et/ou dans le deuxième corps.

Chaque organe de liaison électrique relie électriquement l'un des premiers (24) et l'un des deuxièmes (25) éléments de connexion.

## Description

La présente invention concerne un dispositif de réflectométrie pour la détection de défauts sur un connecteur d'un réseau électrique. Plus précisément, la présente invention concerne un dispositif de réflectométrie du type comportant un premier corps et une pluralité de premiers éléments de connexion, solidaires dudit premier corps ; chacun des premiers éléments de connexion s'étendant parallèlement à un axe principal ; le premier corps et la pluralité de premiers éléments de connexion étant aptes à s'assembler au connecteur dans une configuration d'assemblage.

En particulier, l'invention se rapporte à un dispositif de réflectométrie adapté pour détecter des défauts sur un connecteur multipoints durci d'un réseau électrique.

De tels dispositifs se rencontrent par exemple dans des systèmes de sous-marins, de fusées ou encore de véhicules spatiaux et permettent de détecter des défauts électriques au sein de systèmes complexes et/ou conçus pour des environnements sévères. Un dispositif du type précité est notamment décrit dans le document FR3066825 au nom de la Demanderesse.

Cependant, un tel dispositif implique de tester chaque point de connexion d'un connecteur à l'aide d'un dispositif de réflectométrie configuré pour ledit point de connexion. De multiples opérations de montage et démontage sont donc nécessaires pour tester tous les points de connexion d'un connecteur. Ces opérations sont chronophages et leur répétition peuvent conduire à une dégradation du connecteur.

La présente invention a pour but de proposer un dispositif de réflectométrie permettant de tester chaque point de connexion d'un connecteur à l'aide d'un même appareillage, simplifiant ainsi les opérations de montage et démontage avec ledit connecteur.

A cet effet, l'invention a pour objet un dispositif de réflectométrie du type précité, comprenant en outre : un deuxième corps solidaire du premier corps, les premier et deuxième corps étant alignés selon l'axe principal ; une pluralité de deuxièmes éléments de connexion, solidaires du deuxième corps ; et une pluralité d'organes de liaison électrique, disposés dans le premier corps et/ou dans le deuxième corps, chaque organe de liaison électrique reliant électriquement l'un des premiers et l'un des deuxièmes éléments de connexion.

Suivant d'autres aspects avantageux de l'invention, le dispositif de réflectométrie comporte l'une ou plusieurs des caractéristiques suivantes, prises isolément ou suivant toutes les combinaisons techniquement possibles :
- chaque organe de liaison électrique comprend un câble coaxial s'étendant entre une première et une deuxième extrémités, la deuxième extrémité étant fixée à l'un des deuxièmes éléments de connexion, chaque câble coaxial comprenant une âme conductrice et un blindage ;
- l'âme conductrice de chaque câble coaxial comporte une portion en saillie axiale au niveau de la première extrémité dudit câble coaxial ; et chaque organe de liaison électrique comprend une pièce d'interface s'étendant dans le premier corps entre une première et une deuxième extrémités, ladite première extrémité étant électriquement reliée à l'un des premiers éléments de connexion, ladite deuxième extrémité entourant la portion en saillie axiale de l'âme conductrice dudit câble coaxial ;
- le deuxième corps forme un espace interne disposé axialement entre le premier corps et les deuxièmes éléments de connexion ;
- l'espace interne présente une forme s'évasant axialement du premier corps vers les deuxièmes éléments de connexion.

L'invention se rapporte en outre à un procédé de mise en oeuvre d'un dispositif de réflectométrie tel que décrit ci-dessus, comprenant les étapes suivantes :
- assemblage du dispositif de réflectométrie avec un connecteur dans la configuration d'assemblage, ledit connecteur comprenant une pluralité de troisièmes éléments de connexion, tels que dans ladite configuration d'assemblage, chacun desdits troisièmes éléments de connexion est en contact électrique avec l'un des premiers éléments de connexion du dispositif de réflectométrie ;
- connexion de l'un des deuxièmes éléments de connexion ; et connexion de chacun des autres deuxièmes éléments de connexion du dispositif de réflectométrie avec la terre ou la masse ; puis
- envoi par le réflectomètre d'un signal de sonde vers le deuxième élément de connexion connecté ; puis
- réception d'un éventuel signal réfléchi, émis par le connecteur vers le réflectomètre.

Suivant un aspect avantageux de l'invention, le signal de sonde est un signal hyperfréquence.

L'invention sera mieux comprise à la lecture de la description qui va suivre, donnée uniquement à titre d'exemple non limitatif et faite en se référant aux dessins sur lesquels :
- la figure 1 est une vue en perspective, en coupe partielle, d'un dispositif de réflectométrie selon un mode de réalisation de l'invention ;
- la figure 2 est une vue en coupe du dispositif de réflectométrie de la figure 1, assemblé à un connecteur ; et
- la figure 3 est une vue de détail de la figure 2.

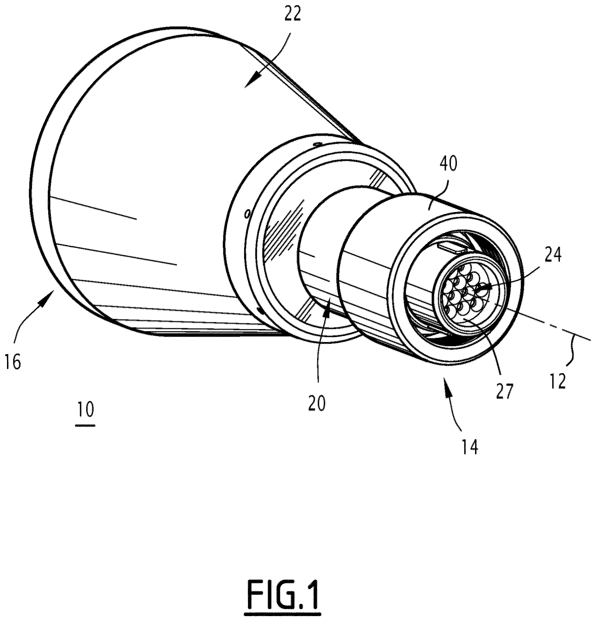

Les figures 1 à 3 représentent un dispositif 10 de réflectométrie selon un mode de réalisation de l'invention.

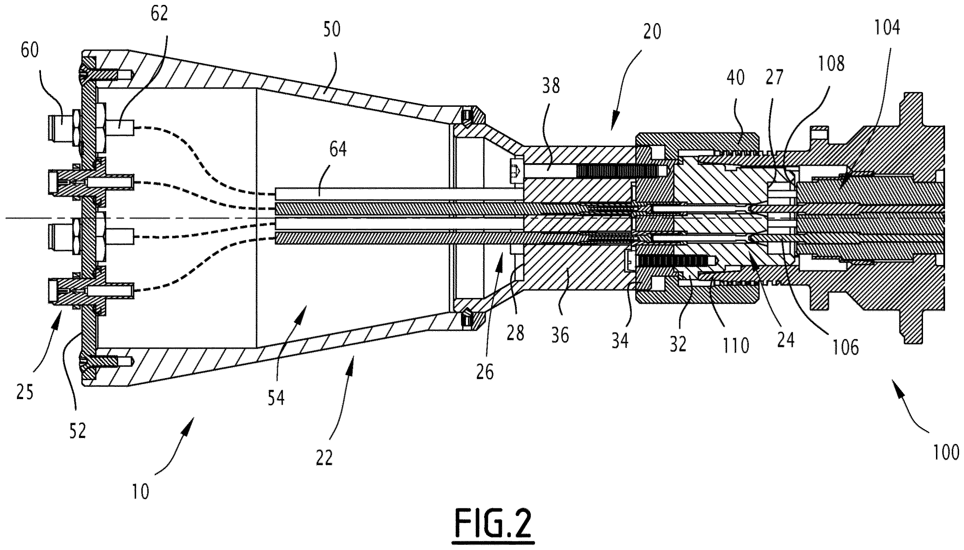

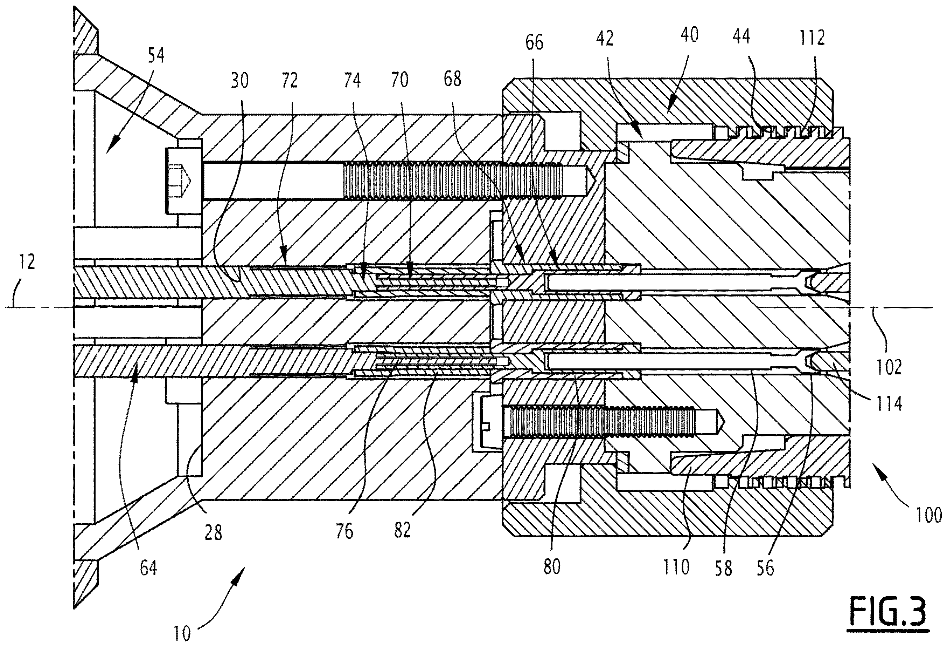

Le dispositif 10 s'étend selon un axe 12 principal, entre une première 14 et une deuxième 16 extrémités. Le dispositif 10 est destiné à être assemblé à un connecteur 100, visible sur les figures 2 et 3.

Le dispositif 10 comprend notamment : un premier 20 et un deuxième 22 corps ; une pluralité de premiers éléments 24 de connexion ; une pluralité de deuxièmes éléments 25 de connexion ; et une pluralité d'organes 26 de liaison électrique.

Les premier 20 et deuxième 22 corps sont alignés selon l'axe 12 principal et disposés respectivement du côté de la première extrémité 14 et de la deuxième extrémité 16.

Le premier corps 20 est sensiblement plein et comporte une première 27 et une deuxième 28 faces frontales, sensiblement perpendiculaires à l'axe 12 principal. La deuxième face frontale 28 est orientée vers le deuxième corps 22. Le premier corps 20 est traversé par des tubulures 30, parallèles à l'axe 12 principal et ouvrant sur chacune des première 27 et deuxième 28 faces frontales.

Dans le mode de réalisation représenté, le premier corps 20 comprend un premier 32, un deuxième 34 et un troisième 36 tronçons, adjacents selon l'axe 12 principal. Les première 27 et deuxième 28 faces frontales sont matérialisées respectivement par le premier 32 et par le troisième 36 tronçons. De préférence, les premier 32, deuxième 34 et troisième 36 tronçons sont assemblés les uns aux autres par des fixations 38 de type vis.

Dans le mode de réalisation représenté, le dispositif 10 comporte en outre une première bague 40 reliée au premier corps 20. Plus précisément, la première bague 40 est mobile en rotation autour du premier corps 20 et mobile selon un jeu axial par rapport audit premier corps 20.

La première bague 40 s'étend selon l'axe 12 principal et est disposée autour du premier tronçon 32, un espace annulaire 42 étant ménagé entre ladite première bague 40 et ledit premier tronçon 32. De préférence, la première bague 40 comporte un moyen d'assemblage avec le connecteur 100, tel qu'un taraudage 44, comme il sera décrit ci-après.

Le deuxième corps 22 comprend une paroi latérale 50 et une paroi d'extrémité 52. La paroi latérale 50 s'étend autour de l'axe 12 principal, entre la deuxième face frontale 28 du premier corps 20 et la paroi d'extrémité 52. Ladite paroi d'extrémité 52 est sensiblement perpendiculaire à l'axe 12 principal.

Le deuxième corps 22 définit un espace interne 54 disposé axialement entre la deuxième face frontale 28 du premier corps 20 et la paroi d'extrémité 52.

Préférentiellement, la paroi latérale 50 présente une forme de révolution autour de l'axe 12 principal. Plus préférentiellement, la paroi latérale 50 présente une forme évasée, par exemple sensiblement tronconique, de sorte que l'espace interne 54 présente une section croissante entre la deuxième face frontale 28 du premier corps 20 et la paroi d'extrémité 52.

Les premiers éléments 24 de connexion sont solidaires du premier corps 20. Dans le mode de réalisation représenté, chaque premier élément 24 de connexion est disposé dans une tubulure 30, à proximité de la première face frontale 27.

Dans le mode de réalisation représenté, chacun des premiers éléments 24 de connexion comporte une cupule 56, orientée vers la première extrémité 14 du dispositif 10. De préférence, chaque tubulure 30 comporte une extrémité tronconique, s'évasant à partir de la cupule 56 correspondante jusqu'à la première face frontale 27. Chaque cupule 56 est apte à assurer un contact électrique avec un élément de connexion du connecteur, comme décrit ci-après.

De préférence, chaque premier élément 24 de connexion est un contact électrique à ressort, tel que décrit dans le document FR3066825. Plus précisément, chaque premier élément 24 de connexion comporte un support 58, inséré dans la tubulure 30 correspondante ; chaque cupule 56 est prolongée par une tige apte à coulisser axialement dans ledit support 58 ; et un ressort (non représenté) est interposé entre une extrémité (non représentée) de ladite tige et un fond du support 58.

Les deuxièmes éléments 25 de connexion sont solidaires du deuxième corps 22. Dans le mode de réalisation représenté, les deuxièmes éléments 25 de connexion sont solidaires de la paroi d'extrémité 52. Plus précisément, chaque deuxième élément 25 de connexion comporte une fiche électrique 60 et une extrémité 62 de raccordement, en saillie axiale de part et d'autre de la paroi d'extrémité 52. Les extrémités 62 de raccordement sont disposées dans l'espace interne 54.

Le dispositif 10 comprend un même nombre de premiers 24 et de deuxièmes 25 éléments de connexion. Dans le mode de réalisation représenté, le dispositif 10 comprend douze premiers éléments 24 de connexion, visibles sur la figure 1, et un même nombre de deuxièmes éléments 25 de connexion.

Lesdits premiers 24 et deuxièmes 25 éléments de connexion sont reliés deux à deux. Plus précisément, chacun des organes 26 de liaison électrique relie un premier 24 et un deuxième 25 éléments de connexion, comme décrit ci-après.

Chaque organe 26 de liaison électrique comprend un câble coaxial 64 et une pièce d'interface 66. Dans le mode de réalisation représenté, chaque organe 26 de liaison électrique comprend en outre un manchon 68.

Chaque câble coaxial 64 s'étend entre une première et une deuxième extrémités, reliées respectivement au premier 24 et au deuxième 25 éléments de connexion correspondants. Plus précisément, la deuxième extrémité de chaque câble coaxial 64 est raccordée à l'extrémité 62 de raccordement du deuxième élément 25 de connexion correspondant. La première extrémité du câble coaxial sera plus précisément décrite ci-après.

De préférence, une longueur d'au moins l'un des câbles coaxiaux 64 est supérieure à une distance axiale entre les premier 24 et deuxième 25 éléments de connexion correspondants, afin de facilité les opérations de connexion. A proximité des deuxièmes éléments 25 de connexion, l'au moins un câble coaxial 64 est donc disposé de manière recourbée, comme représenté en pointillés sur la figure 2. La forme évasée de l'espace interne 54 permet de recevoir une telle disposition spatiale des câbles coaxiaux 64.

Chaque câble coaxial 64 comprend une âme 70 conductrice, un blindage 72 et un isolant 74 électrique. L'isolant 74 est disposé autour de l'âme 70 conductrice et le blindage 72, également conducteur, est disposé autour de l'isolant 74. L'âme 70 conductrice et le blindage 72 sont préférentiellement métalliques.

Dans le mode de réalisation représenté, l'âme 70 conductrice de chaque câble coaxial comporte une portion 76 d'extrémité, en saillie axiale par rapport à l'isolant 74 au niveau de la première extrémité dudit câble coaxial.

Chaque pièce d'interface 66 s'étend dans le premier corps 20 entre une première 80 et une deuxième 82 extrémités. Ladite première extrémité 80 est électriquement reliée au premier élément 24 de connexion correspondant. Dans le mode de réalisation représenté, le fond du support 58 dudit premier élément 24 de connexion correspondant est inséré dans la première extrémité 80.

Par ailleurs, la portion 76 d'extrémité de l'âme 70 conductrice du câble coaxial 64 correspondant est insérée dans la deuxième extrémité 82 de la pièce d'interface 66. Un contact électrique optimal est ainsi assuré entre le premier élément 24 de connexion et le câble coaxial 64 correspondant.

Dans le mode de réalisation représenté, le manchon 68 est disposé autour de la pièce d'interface 66 et inséré dans la tubulure 30 correspondante, de sorte à maintenir ladite pièce d'interface 66 dans ladite tubulure 30 et à réaliser une isolation électrique entre l'élément 24 et le corps 20.

Le connecteur 100, visible sur les figures 2 et 3, va à présent être décrit.

Le connecteur 100 s'étend selon un axe 102 de connecteur et comporte un troisième corps 104 et une pluralité de troisièmes éléments 106 de connexion.

Le troisième corps 104 comporte : une surface frontale 108, sensiblement perpendiculaire à l'axe 102 de connecteur ; et une deuxième bague 110, s'étendant selon l'axe 102 de connecteur à partir de ladite surface frontale 108. Dans le mode de réalisation représenté, la deuxième bague 110 comporte un moyen d'assemblage avec le dispositif 10 de réflectométrie, tel qu'un filetage 112, comme il sera décrit ci-après.

Chacun des troisièmes éléments 106 de connexion est disposé en saillie axiale par rapport à la surface frontale 108 du troisième corps 104, la deuxième bague 110 étant disposée autour desdits troisièmes éléments 106 de connexion. Chacun des troisièmes éléments 106 de connexion comporte une extrémité libre 114, opposée à la surface frontale 108.

Le connecteur 100 comprend un nombre de troisièmes éléments 106 de connexion inférieur ou égal au nombre de premiers éléments 24 de connexion du dispositif 10. De préférence, les nombres de premiers 24 et de troisièmes 106 éléments de connexion sont égaux.

En particulier, le dispositif 10 de réflectométrie et le connecteur 100 sont configurés pour s'assembler de manière réversible, de sorte à mettre en contact électrique chacun des troisièmes éléments 106 de connexion avec un premier élément 24 de connexion correspondant.

Plus précisément, dans une configuration assemblée, visible sur les figures 2 et 3, l'extrémité libre 114 de chacun des troisièmes éléments 106 de connexion est reçue dans la cupule 56 du premier élément 24 de connexion correspondant. De préférence, dans ladite configuration assemblée, le ressort dudit premier élément 24 de connexion est comprimé.

De préférence, dans la configuration assemblée, la deuxième bague 110 est reçue dans l'espace annulaire 42 ménagé entre la première bague 40 et le premier corps 20 ; et le taraudage 44 de ladite première bague et le filetage 112 de ladite deuxième bague sont assemblés l'un à l'autre, comme visible sur les figures 2 et 3.

Un procédé de mise en oeuvre du dispositif 10 de réflectométrie décrit ci-dessus va maintenant être décrit.

Un tel procédé vise par exemple à détecter des défauts sur le connecteur 100 et/ou sur un système électrique raccordé audit connecteur 100. Un tel système électrique est par exemple incorporé à un équipement complexe et/ou conçu pour des conditions d'utilisation particulières, comme par exemple un équipement de sous-marin, de fusée ou de véhicule spatial.

Dans une première étape du procédé, le dispositif 10 décrit ci-dessus est assemblé au connecteur 100 dans la configuration assemblée décrite ci-dessus. Plus précisément, l'extrémité libre 114 de chacun des troisièmes éléments 106 de connexion est insérée axialement dans la cupule 56 du premier élément 24 de connexion correspondant ; puis la première bague 40 du dispositif 10 est vissée sur la deuxième bague 110 du connecteur 100.

Dans une deuxième étape du procédé, la fiche 60 de l'un des deuxièmes éléments 25 de connexion est reliée à un réflectomètre (non représenté) ; et la fiche 60 de chacun des autres deuxièmes éléments 25 de connexion est reliée à la terre ou à la masse. La deuxième étape du procédé est réalisée avant ou après la première étape.

Dans une troisième étape du procédé, le réflectomètre envoie un signal de sonde vers le deuxième élément 25 de connexion qui lui est relié. Préférentiellement, il s'agit d'un signal de fréquence élevée, plus préférentiellement d'un signal hyperfréquence.

Le dispositif 10 est apte à assurer une continuité d'impédance entre chacun des deuxièmes éléments 25 de connexion et le premier élément 24 de connexion correspondant, avec une qualité suffisante pour un signal hyperfréquence. Le signal émis par le réflectomètre lors de la troisième étape est donc transmis au troisième élément 106 de connexion assemblé au premier élément 24 de connexion correspondant.

En cas de défaut au niveau dudit connecteur 100 et/ou sur un système électrique raccordé audit connecteur 100, la discontinuité d'impédance associée audit défaut conduit au renvoi d'un signal réfléchi vers le réflectomètre. Le défaut est ainsi détecté.

Les deuxième et troisième étapes sont répétées avec chacun des deuxièmes éléments 25 de connexion, afin de tester successivement chacun des troisièmes éléments 106 de connexion correspondants du connecteur 100.

La présence d'éventuels défauts au niveau du connecteur 100 est ainsi testée de manière non invasive, sans multiplier d'opérations de montage/démontage au niveau dudit connecteur. La qualité de la connexion du réflectomètre sur le connecteur 100 permet la reproductibilité des mesures.

## Revendications

1. Dispositif (10) de réflectométrie pour la détection de défauts sur un connecteur (100) d'un réseau électrique ;
le dispositif de réflectométrie comprenant : un premier corps (20) ; et une pluralité de premiers éléments (24) de connexion, solidaires dudit premier corps ; chacun des premiers éléments de connexion s'étendant parallèlement à un axe (12) principal ; le premier corps (20) et la pluralité de premiers éléments (24) de connexion étant aptes à s'assembler au connecteur (100) dans une configuration d'assemblage ;
le dispositif de réflectométrie étant **caractérisé en ce qu'**il comprend en outre : un deuxième corps (22) solidaire du premier corps, les premier et deuxième corps étant alignés selon l'axe (12) principal ; une pluralité de deuxièmes éléments (25) de connexion, solidaires du deuxième corps ; et une pluralité d'organes (26) de liaison électrique, disposés dans le premier corps et/ou dans le deuxième corps, chaque organe de liaison électrique reliant électriquement l'un des premiers (24) et l'un des deuxièmes (25) éléments de connexion.

2. Dispositif (10) de réflectométrie selon la revendication 1, dans lequel chaque organe (26) de liaison électrique comprend un câble coaxial (64) s'étendant entre une première et une deuxième extrémités, la deuxième extrémité étant fixée à l'un des deuxièmes éléments (25) de connexion, chaque câble coaxial comprenant une âme (70) conductrice et un blindage (72).

3. Dispositif de réflectométrie selon la revendication 2, dans lequel : l'âme (70) conductrice de chaque câble coaxial comporte une portion (76) en saillie axiale au niveau de la première extrémité dudit câble coaxial ; et chaque organe de liaison électrique comprend une pièce (66) d'interface s'étendant dans le premier corps (20) entre une première (80) et une deuxième (82) extrémités, ladite première extrémité étant électriquement reliée à l'un des premiers éléments (24) de connexion, ladite deuxième extrémité entourant la portion (76) en saillie axiale de l'âme (70) conductrice dudit câble (64) coaxial.

4. Dispositif de réflectométrie selon l'une des revendications précédentes, dans lequel le deuxième corps (22) forme un espace interne (54) disposé axialement entre le premier corps (20) et les deuxièmes éléments (25) de connexion.

5. Dispositif de réflectométrie selon la revendication 4, dans lequel l'espace interne (54) présente une forme s'évasant axialement du premier corps (20) vers les deuxièmes éléments (25) de connexion.

6. Procédé de mise en oeuvre d'un dispositif (10) de réflectométrie selon l'une des revendications précédentes, comprenant les étapes suivantes :
- assemblage du dispositif de réflectométrie avec un connecteur (100) dans la configuration d'assemblage, ledit connecteur comprenant une pluralité de troisièmes éléments (106) de connexion, tels que dans ladite configuration d'assemblage, chacun desdits troisièmes éléments (106) de connexion est en contact électrique avec l'un des premiers éléments (24) de connexion du dispositif de réflectométrie ;
- connexion de l'un des deuxièmes éléments (25) de connexion ; et connexion de chacun des autres deuxièmes éléments (25) de connexion du dispositif de réflectométrie avec la terre ou la masse ; puis
- envoi par le réflectomètre d'un signal de sonde vers le deuxième élément (25) de connexion connecté ; puis
- réception d'un éventuel signal réfléchi, émis par le connecteur (100) vers le réflectomètre.

7. Procédé selon la revendication 6, dans lequel le signal de sonde est un signal hyperfréquence.
